# EUROPÄISCHE PATENTSCHRIFT

(11) **EP 0 555 668 B1**
(45) Veröffentlichungstag und Bekanntmachung des Hinweises auf die Patenterteilung: **25.10.1995**
(21) Anmeldenummer: 93100862.7
(22) Anmeldetag: 21.01.1993
(51) Int. Cl.: H05K 7/20, H05K 3/34

(54) **Leiterkarte für eine Leistungshalbleiter aufweisende Leistungselektronikschaltung**
Printed circuit board for electronical power circuit containing power semiconductors
Plaquette à circuit imprimé pour un circuit électronique de puissance contenant des semiconducteurs à grande puissance

(30) Priorität: 14.02.1992 DE 4204391
(43) Veröffentlichungstag der Anmeldung: 18.08.1993
(73) Patentinhaber: Rheinmetall Industrie Aktiengesellschaft, 40880 Ratingen (DE)
(72) Erfinder: Graener, Rudolf, Dr., W-4006 Erkrath (DE); von der Lippe, Norbert, W-4130 Moers (DE); Sommer, Peter, W-5020 Frechen 4 (DE)

(56) Entgegenhaltungen:
- EP-A- 0 139 431
- EP-A- 0 291 400
- WO-A-91/15938
- FR-A- 2 413 016
- FR-A- 2 670 074

## Beschreibung

Die Erfindung betrifft eine Leiterkarte für eine Leistungshalbleiter aufweisende Leistungelektronikschaltung nach dem Oberbegriff des Anspruchs 1.

Eine derartige Leiterkarte ist aus der DE-OS 40 10 193 bekannt. Sie besteht aus einem eine hohe mechanische Festigkeit aufweisenden Stahlhybridsubstrat, d.h. einem plattenförmigen Stahlteil, welches mit einem elektrisch isolierenden, anorganischen Material, wie Glas, Keramik, Email oder Glaskeramik, beschichtet ist. Auf der unbestückten Seite bildet die Leiterkarte die Innenwand eines von einem flüssigen oder gasförmigen Kühlmittel durchströmten Gehäuses, um die hohe Verlustleistung der Leistungshalbleiter abzuführen. Hierbei wird zwar eine Kühlung der Leiterkarte erreicht, jedoch ist die Wärmeabführung von den Leistungshalbleitern, die gewöhnlich mittels eines elastischen Klebers auf die Leiterkarte aufgeklebt werden, aufgrund des vorhandenen thermischen Widerstandes zwischen dem Leistungshalbleiter und der Wärmesenke verbesserungsbedürftig.

Aus der EP-A-0 139 431 ist eine Leiterkarte bekannt, auf der sich jeweils mit einem Gehäuse versehene Halbleiterbauelemente befinden. Zur Kühlung des jeweiligen Halbleiterbauelementes wird sein Gehäuse über eine den Abmessungen des Bauelementes entsprechende metallische Verbindung mit einer wärmeleitenden Schicht verbunden. Die wärmeleitende Schicht ist dabei sandwichartig zwischen zwei elektrisch isolierenden Schichten der Leiterplatte angeordnet.

Aufgabe der Erfindung ist es daher, eine Leiterkarte nach dem Oberbegriff des Anspruchs 1 zu schaffen, bei der gegenüber bekannten Leiterkarten die Wärmeabfuhr von den Leistungshalbleitern zu einer Wärmesenke verbessert wird.

Diese Aufgabe wird entsprechend dem kennzeichnenden Teil des Anspruchs 1 gelöst.

Weitere Ausgestaltungen der Erfindung sind der nachfolgenden Beschreibung und den Unteransprüchen zu entnehmen.

Die Erfindung wird nachstehend anhand des in den beigefügten Abbildungen dargestellten Ausführungsbeispiels näher erläutert.

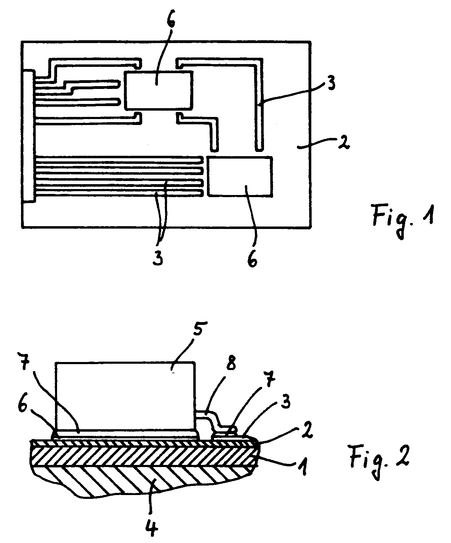

Fig. 1 zeigt schematisch eine Draufsicht auf eine Leiterkarte.

Fig. 2 zeigt im Schnitt ausschnittweise eine Leiterkarte mit montiertem Leistungshalbleiter.

Die dargestellte Leiterkarte umfaßt ein Stahlsubstrat 1 einer Stärke von beispielsweise 0,5 bis 6 mm, das einseitig mit einer Isolierschicht 2 aus Glas, Keramik, Email oder Glaskeramik in einer Stärke von beispielsweise 100 µm versehen ist. Auf der Isolierschicht 2 sind Leiterbahnen 3 aufgedruckt, die beispielsweise aus Silber, das mit Platin und Palladium legiert ist, oder aus Kupfer oder Gold bestehen. Die Leiterbahnen 3 haben gewöhnlich eine Schichtstärke in der Größenordnung von 10 µm.

Das Stahlsubstrat 1 steht mit einer Wärmesenke 4 in unmittelbarem Kontakt, indem das Stahlsubstrat 1 beispielsweise eine Innenwand eines von einem flüssigen oder gasförmigem Kühlmittel durchströmten Gehäuses bildet. Stattdessen kann das Stahlsubstrat 1 aber auch mit einem Peltierelement in Kontakt stehen.

Auf die Isolierschicht 2 sind ferner entsprechend der Anzahl der auf der Leiterkarte benötigten Leistungshalbleiter 5 Inseln 6 aus metallischem Material aufgedruckt. Die Inseln 6 bestehen insbesondere aus dem gleichen Material wie die Leiterbahnen 3 und werden zusammen mit diesen sowie in gleicher Schichtstärke aufgedruckt. Die Inseln 6 sind elektrisch isoliert von den Leiterbahnen 3 angeordnet und haben eine Größe entsprechend der Kühlfläche des jeweiligen Leistungshalbleiters 5.

Die Leistungshalbleiter 5 werden auf den Inseln 6 vollflächig aufgelötet, indem zunächst eine Lötpaste 7, beispielsweise aus ZnPbAg, aufgebracht und nach Aufsetzen der Leistungshalbleiter 5 insbesondere mittels einer Bestückungsmaschine diese etwa im Reflow-Verfahren aufgelötet. Vor dem Bestücken werden die Anschlußkontakte 8 der Leistungshalbleiter 5 - und eventuell anderer Bauteile wie Widerstände, Kondensatoren o.dgl. - für die Oberflächenmontage (SMD-Bestückung) vorgebogen, um zusammen mit den Leistungshalbleitern 5 mit den entsprechenden Leiterbahnen 3 verlötet zu werden. Auf diese Weise können sowohl gehäuste als auch ungehäuste Bauelemente mit dem gleichen Lötverfahren, z.B. Reflowlöten, befestigt werden. Gegebenenfalls ist die Verwendung eines anderen Leiterbahnmaterials zum Befestigen von ungehäusten Bauelementen zweckmäßig.

Die Verwendung der Inseln 6 zum vollflächigen Auflöten der Leistungshalbleiter 5 mit ihren Kühlflächen ermöglicht nicht nur eine einfache Montage, sondern sichert auch eine gute Wärmeleitfähigkeit zum Stahlsubstrat 1 und von dort zur Wärmesenke 4 und damit eine wesentliche Reduzierung des geringen thermischen Widerstandes zur Abführung der hohen Verlustleistung.

## Patentansprüche

1. Leiterkarte für eine Leistungshalbleiter (5) aufweisende Leistungselektronikschaltung in einseitiger SMD-Bestükkung, wobei die unbestückte Seite der Leiterkarte, die aus einem Stahlhybridsubstrat (1) mit darauf einseitig aufgedruckten, mit Anschlußkontakten (7) der Leistungshalbleiter (5) verbindbaren Leiterbahnen (3) besteht, an eine Wärmesenke (4) anschließbar ist, **dadurch gekennzeichnet**, daß auf der Bestückungsseite der Leiterkarte von den Leiterbahnen (3) elektrisch isolierte, metallische Inseln (6) entsprechend der Größe der Leistungshalbleiter (5) aufgedruckt sind, wobei die Leistungshalbleiter (5) mit ihren Kühlflächen flächig mit den metallischen Inseln (6) verlötbar sind.

2. Leiterkarte nach Anspruch 1, dadurch gekennzeichnet, daß die metallischen Inseln (6) aus dem Leiterbahnmaterial besteht.

3. Leiterkarte nach Anspruch 1 oder 2, dadurch gekennzeichnet, daß die metallischen Inseln (6) aus Silber bzw. einer Silberlegierung bestehen.

4. Leiterkarte nach Anspruch 1 oder 2, dadurch gekennzeichnet, daß die metallischen Inseln (6) aus Kupfer oder Gold bestehen.

## Claims

1. Printed circuit board for an electronic power circuit which has power semi-conductors (5) and which has SMD components on one side, while the non-component side of the circuit board, which consists of a steel hybrid substrate (1) with conductor tracks (3) printed thereon and connected with contacts (7) of the power semi-conductors (5), is connected to a heat sink (4), characterised by the fact that metallic pads (6) which are electrically insulated from the conductor tracks (3) are printed on the component side of the circuit board in accordance with the size of the power semi-conductors (5), the cooling surfaces of the power semi-conductors (5) being solderable over their whole area to the metallic pads (60).

2. Printed circuit board in accordance with Claim 1, characterised by the fact that the metallic pads (6) are made of the same material as the circuit board tracks.

3. Printed circuit board in accordance with Claim 1 or 2, characterised by the fact that the metallic pads (6) consist of silver or a silver alloy.

4. Circuit board in accordance with Claim 1 or 2, characterised by the fact that the metallic pads (6) consist of copper or gold.

## Revendications

1. Carte de circuits imprimés pour un circuit électronique de puissance comportant des semi-conducteurs de grande puissance (5) avec équipement SMD sur une face, la face non équipée de la carte de circuits imprimés, qui est constituée d'un substrat hybride d'acier (1) avec des pistes conductrices (3) imprimées sur une face de celui-ci, a relier avec des contacts de branchement (7) des semi-conducteurs de puissance (5), pouvant être raccordée à un dissipateur thermique (4), caractérisée en ce que sur la face équipée de la carte de circuits imprimés sont imprimés des îlots métalliques (6), électriquement isolés des pistes conductrices (3), correspondant à la grandeur des semi-conducteurs de puissance (5), les semi-conducteurs de puissance (5) pouvant être soudés à plat par leur surface de refroidissement avec les îlots métalliques (6).

2. Carte de circuits imprimés selon la revendication 1, caractérisée en ce que les îlots métalliques (6) sont constitués du matériau des pistes conductrices.

3. Carte de circuits imprimés selon la revendication 1 ou 2, caractérisée en ce que les îlots métalliques (6) sont en argent ou dans un alliage d'argent.

4. Carte de circuits imprimés selon la revendication 1 ou 2, caractérisée en ce que les îlots métalliques (6) sont en cuivre ou en or.
